# EUROPEAN PATENT APPLICATION

(11) **EP 2 073 226 A2**
(43) Date of publication of application: **24.06.2009**
(21) Application number: 08171283.8
(22) Date of filing: 11.12.2008
(51) Int. Cl.: H01G 9/20

(54) **Dye-sensitized solar cell and method of manufacturing the same**

(30) Priority: 17.12.2007 KR 20070132640
(71) Applicant: Electronics and Telecommunications Research Institute, Daejeon-city 305-350 (KR)
(72) Inventor: Jun, Yongseok, Daejeon-city (KR); Kang, Mangu, Yuseong-gu Daejeon-city (KR); Lee, Seungyup, Gyeongsangbuk-Do (KR); Kim, Jongdae, Yuseong-gu Daejeon-city (KR)
(74) Representative: Betten & Resch

(57) **Abstract**

Provided are a dye-sensitized solar cell and a method of manufacturing the same. The dye-sensitized solar cell includes: a semiconductor electrode and a counter electrode that face each other, and an electrolytic solution interposed therebetween, wherein the semiconductor electrode includes: a conductive substrate; a nanorod-nanoparticle composite formed on the conductive substrate; and dyes adsorbed onto the surface of the nanoparticles. The dye-sensitized solar cell manufactured using the method can have high efficiency by significantly reducing loss of produced electrons.

## Description

### CROSS-REFERENCE TO RELATED PATENT APPLICATION

This application claims the benefit of Korean Patent Application No. 10-2007-0132640, filed on December 17, 2007, in the Korean intellectual Property Office, the disclosure of which is incorporated herein in its entirety by reference.

### BACKGROUND OF THE INVENTION

### 1. Field of the Invention

The present invention relates to a dye-sensitized solar cell and a method of manufacturing the same, and more particularly, to a dye-sensitized solar cell with high efficiency in which loss of produced electrons is significantly reduced, and a method of manufacturing the same. The work was supported by the IT R&D program of MIC/IITA [2006-S-006-02, Components/Module technology for Ubiquitous Terminals].

### 2. Description of the Related Art

Unlike wafer-type silicon solar cells using p-n junction or compound solar cells, dye-sensitized solar cells are photo-electrochemical solar cells that primarily comprise photosensitive dye molecules capable of generating electron-hole pairs by absorbing incident light having a wavelength of visible light, semiconductor oxides capable of receiving excited electrons, and an electrolyte that reacts with electrons transported back after performing electrical work in an external circuit. Gratzel cells disclosed in U.S. Patent Nos. 4,927,721 and 5,350,644, issued to Gratzel et al. (Switzerland) are representative dye-sensitized solar cells. These dye-sensitized solar cells include an oxide semiconductor electrode formed of a nanoparticle titanium dioxide (TiO₂) onto which dye molecules are adsorbed, a counter electrode coated with platinum or carbon, and an electrolytic solution filled between the oxide semiconductor electrode and the counter electrode. These photo-electrochemical solar cells can be manufactured at lower costs per unit of power, as compared with wafer-type silicon solar cells using p-n junctions, and thus have attracted widespread interest.

The principle of operation of a dye-sensitized solar cell will now be explained. Electrons from photosensitive dyes excited by sunlight are injected into a conduction band of the nanoparticle TiO₂. The injected electrons pass through the nanoparticle TiO₂ to reach a conductive substrate and are transferred to an external circuit. After performing electrical work in the external circuit, the electrons are transferred back into the nanoparticle TiO₂ through the counter electrode by an oxidation/reduction electrolyte so as to reduce photosensitive dyes having insufficient electrons, thereby completing the operation of the dye-sensitized solar cell.

Here, when the electrons injected from the photosensitive dyes pass through the nanoparticles TiO₂ layer and the conductive substrate before reaching the external circuit, some of the injected electrons may remain in an empty surface energy level on the surface of the nanoparticle TiO₂ layer. In this case, the electrons react with the oxidation/reduction electrolyte, and are removed inefficiently instead of moving through the circuit. In addition, the electrons generated by light may also react with the oxidation/reduction electrolyte and may be lost on the surface of the conductive substrate, thereby decreasing photoelectron conversion efficiency.

### SUMMARY OF THE INVENTION

The present invention provides a dye-sensitized solar cell with high efficiency, which significantly reduces loss of produced electrons.

The present invention also provides a method of manufacturing a dye-sensitized solar cell with high efficiency, which significantly reduces loss of produced electrons.

According to an aspect of the present invention, there is provided a dye-sensitized solar cell comprising: a semiconductor electrode and a counter electrode that face each other, and an electrolytic solution interposed therebetween, wherein the semiconductor electrode comprises: a conductive substrate; a nanorod-nanoparticle composite formed on the conductive substrate and dyes adsorbed onto the surface of the nanoparticles. In particular, in the nanorod-nanoparticle composite, the nanorods may be electrically connected to the conductive substrate, and may be covered by a layer formed of the nanoparticles, the nanoparticles comprising an oxide semiconductor. In addition, one end of each of the nanorods may be attached to the conductive substrate.

The length of the nanorods may be in a range of about 1 µm to about 10 µm, and the thickness of the layer formed of the nanoparticles may be in a range of about 5 µm to about 15 µm. In addition, the thickness of the nanorods may be in a range of about 10 nm to about 30 nm, and the size of the nanoparticles may be in a range of about 10 nm to about 40 nm.

An integration degree of the nanorods may be in a range of 1 to 10%, and the nanorods may comprise zinc oxide or carbon. The nanoparticles may comprise one selected from the group consisting of titanium dioxide (TiO₂), tin dioxide (SnO₂), zinc oxide (ZnO), tungsten oxide (WO₃), niobium oxide (Nb₂O₅), titanium oxide strontium (TiSrO₃), and a combination thereof.

According to another aspect of the present invention, there is provided a method of manufacturing a dye-sensitized solar cell, comprising: forming a semiconductor electrode; forming a counter electrode; disposing the semiconductor electrode and the counter electrode to face each other; and injecting an electrolytic solution between the semiconductor electrode and the counter electrode, wherein the forming of the semiconductor electrode comprises: providing a conductive substrate; growing nanorods on the conductive substrate; forming nanoparticles covering the nanorods to form a nanorod-nanoparticle composite; and adsorbing dyes onto the nanorod-nanoparticle composite.

In particular, the method of manufacturing the dye-sensitized solar cell may further comprise: pre-treating the surface of the conductive substrate with organic molecules having a functional group, wherein the organic molecules are capable of being self-assembled on the nanoparticles by a selective chemical binding between the functional group and the nanoparticles, before the growing of the nanorods on the conductive substrate, and performing heat treatment for removing the organic molecules after the growing of the nanorods on the conductive substrate.

The heat treatment may be performed at a temperature in a range of about 100°C to about 500°C for about 30 minutes to about 4 hours in an oxygen atmosphere.

The growing of the nanorods on the conductive substrate may comprise growing the nanorods to have an integration degree of 1 to 10%.

In particular, the growing of the nanorods on the conductive substrate may comprise: forming a seed layer on the conductive substrate; and growing nanorods from the seed layer. In addition, the seed layer may be formed by thermal deposition, sputtering, or spin coating.

The dye-sensitized solar cell manufactured using the method can have high photoelectron conversion efficiency by significantly reducing loss of produced electrons.

### BRIEF DESCRIPTION OF THE DRAWING

The above and other features and advantages of the present invention will become more apparent by describing in detail exemplary embodiments thereof with reference to the attached drawings in which:
FIG. 1 is a cross-sectional view illustrating a main structure of a dye-sensitized solar cell according to an embodiment of the present invention;
FIG. 2 is a partial cross-sectional view of the dye-sensitized solar cell of FIG. 1, wherein a portion of a semiconductor electrode of the dye-sensitized solar cell is exaggeratedly expanded;
FIG. 3 is a flowchart showing a method of manufacturing a dye-sensitized solar cell, according to an embodiment of the present invention;
FIG. 4 is an image of a dye-sensitized solar cell manufactured in Example; and
FIG. 5 is a graph showing current density and voltage characteristics of dye-sensitized solar cells manufactured in Example and Comparative Example.

### DETAILED DESCRIPTION OF THE INVENTION

Hereinafter, exemplary embodiment of the present invention will be described in more detail with reference to the accompanying drawings.

Exemplary embodiments of the present invention may be embodied in many different forms and should not be construed as being limited to embodiments set forth herein. Rather, these embodiments are provided so that this disclosure will be thorough and complete. In the present specification, it will be understand that when a layer is referred to as being "on" another layer or substrate, it can be directly on the other layer or substrate, or intervening layers may also be present. In the accompanying drawings, thicknesses and sizes of layers and regions are exaggerated for clarity. Thus, the present invention is not limited to the relative sizes or intervals shown in the accompanying drawings. The same reference numerals refer to the same constitutional elements throughout the drawings.

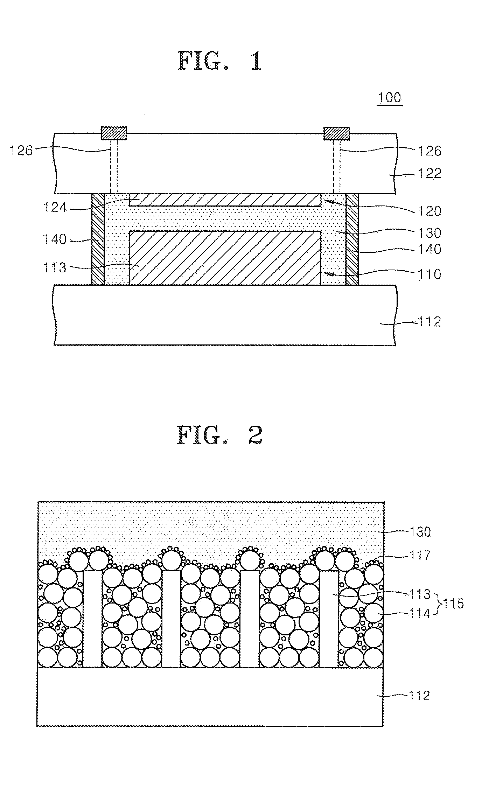

FIG. 1 is a cross-sectional view illustrating a main structure of a dye-sensitized solar cell 100 according to an embodiment of the present invention.

Referring to FIG. 1, the dye-sensitized solar cell 100 according to the current embodiment of the present invention includes a semiconductor electrode 110 and a counter electrode 120 that face each other, and an electrolyte layer 130 interposed between the semiconductor electrode 110 and the counter electrode 120.

FIG. 2 is a partial cross-sectional view of the dye-sensitized solar cell 100 of FIG. 1, wherein a portion of the semiconductor electrode 110 is exaggeratedly expanded.

Referring to FIG. 2, the semiconductor electrode 110 includes a conductive substrate 112, a nanorod-nanoparticle composite 115 formed on the conductive substrate 112, and dyes 117 adsorbed onto the surface of the nanoparticles 114.

The conductive substrate 112 may be formed of, for example, indium tin oxide (ITO), indium zinc oxide (IZO), fluorine-doped tin oxide (FTO), ZnO-Ga₂O₃, ZnO-Al₂O₃, SnO₂-Sb₂O₃, or the like, or may be glass substrate of which surface is coated with SnO₂. However, the present invention is not limited to the above

### examples.

The nanorod-nanoparticle composite 115 includes nanorods 113 and nanoparticles 114, wherein the nanorods 113 are electrically connected to the conductive substrate 112. The nanorods 113 may grow in a direction perpendicular to the conductive substrate 112. Alternatively, the nanorods 113 may grow at an angle of 45°, other angles, or different angles to each other. In particular, one end of each of the nanorods 113 may be attached to the conductive substrate 112.

As shown in FIG. 2, the nanorods 113 may be formed on the conductive substrate 112, and a layer formed of the nanoparticles 114 may be formed between the nanorods 113 and on a top surface of the nanorods 113. The thickness of the nanorods 113 may be in a range of about 10 nm to about 30 nm, and the length thereof may be in a range of about 1 µm to about 10 µm. The size of the nanoparticles 114 may be in a range of about 10 nm to about 40 nm, and the thickness of the layer of the nanoparticles 114 may be in a range of about 5 µm to about 15 µm. The nanorods 113 may be covered by the layer of the nanoparticles 114. The nanorods 113 may be formed of ZnO or carbon.

The nanorods 113 formed on the conductive substrate 112 directly transfer electrons that are generated in the dyes 117 and then transferred through the layer of the nanoparticles 114, to the conductive substrate 112. If the nanorods 113 do not exist, all the generated electrons have to pass through the thick layer of the nanoparticles 114 and then be transferred to the conductive substrate 112. In addition, the amount of contact between the nanoparticles 114 is relatively low, which is disadvantageous in electron transfer. By contrast, the nanorods 113 significantly reduce distances through which the generated electrons must pass, and also substantially increase the surface area of a conductor. Thus, this compensates for the low contact between the nanoparticles 114.

An integration degree of the nanorods 113 formed on the conductive substrate 112 directly affects the performance of the dye-sensitized solar cell 100. If the integration degree of the nanorods 113 on the conductive substrate 112 is too low, improvements in the performance of the dye-sensitized solar cell 100 achieved by the effects described above are very insignificant. On the other hand, if the integration degree of the nanorods 113 on the conductive substrate 112 is too high, the nanoparticles 114 cannot be distributed between the nanorods 113, and thus are formed as a separate layer on the nanorods 113. Consequently, this may not reduce distances through which electrons pass, and also may not increase the surface area of a conductor. In this regard, the integration degree of the nanorods 113 may be in a range of 1 to 10%. Herein, the integration degree is defined as a percentage of the ratio of a cross-section of the nanorods 113 to a unit surface area of the conductive substrate 112.

The nanoparticles 114 may comprise an oxide semiconductor. The oxide semiconductor may be, for example, titanium dioxide (TiO₂), tin dioxide (SnO₂), zinc oxide (ZnO), tungsten oxide (WO₃), niobium oxide (Nb₂O₅), titanium strontium oxide (TiSrO₃) or a combination thereof. In particular, the oxide semiconductor may be titanium dioxide in an anatase form.

As described above, the size of the nanoparticles 114 may be in a range of about 10 nm to about 40 nm. Herein, the size of the nanoparticle 114 is defined as a distance between two points furthest away from each other in a particle.

The dyes 117 coated on the oxide semiconductor may be any dye that is commonly used in solar cells without limitation, that has charge separation functions, and that can be photosensitive. Examples of the dyes may include a ruthenium complex, a xanthine based dye such as rhodamine B, Rose Bengal, eosin, or erythrosine; a cyanine based dye such as quinocyanin or cryptocyanine; a basic dye such as phenosafranine, capri blue, thiosine, or methylene blue; a porphyrin based compound such as chlorophyll, zinc porphyrin, or magnesium porphyrin; an azo dye; a phthalocyanine compound; a ruthenium tris-bipyridyl based complex compound; an anthraquinone based dye; a polycyclic quinone based dye; and a single or a mixture of at least two of the above materials can be used as the dye. In particular, the ruthenium complex can be RuL₂(SCN)₂, RuL₂(H₂O)₂, RuL₃, or RuL₂ wherein L can be 2,2'-bipyridyl-4,4'-dicarboxylate.

The electrolyte layer 130 may include an imidazole-based compound and iodine. For example, the electrolyte layer 130 can be a layer in which an iodine-based oxidation-reduction electrolyte (I⁻/I₃⁻) is dissolved. The electrolyte layer 130 may be formed of, for example, an electrolytic solution obtained by dissolving 0.70 M of 1-vinyl-3-methyl-imidazolium iodide, 0.10 M of Lil, 40 mM of I₂ and 0.125 M of 4-*tert*-butylpyridine in 3-methoxypropionitrile.

The counter electrode 120 may include an electrically conductive substrate 122 for a counter electrode and a metallic layer 124 coated on the electrically conductive substrate 122 for a counter electrode. In particular, the metallic layer 124 may be, for example, a platinum layer. In addition, the conductive substrate 122 for a counter electrode may be formed of ITO or fluorine-doped tin oxide (FTO), or may be a glass substrate of which surface is coated with tin oxide.

The metallic layer 124 of the counter electrode 120 may be disposed to face the semiconductor electrode 110.

The operation of the dye-sensitized solar cell 100 according to the current embodiment of the present invention and as illustrated in FIGS. 1 and 2, will now be described.

When light that is transmitted through the conductive substrate 112 of the semiconductor electrode 110 reaches the dyes 117 adsorbed onto the oxide semiconductor 114, molecules of the dyes 117 are excited. As a result, electrons are injected into a conduction band of the oxide semiconductor 114. The electrons injected into the oxide semiconductor 114 are easy to be transferred to the conductor 113 coated by the oxide semiconductor 114, and then are transferred to an external circuit (not shown) via the conductive substrate 112. The electrons that perform electrical work in the external circuit (not shown) are transferred to the counter electrode 120.

The dyes 117 oxidized as a result of the electron transition receive electrons provided by oxidation and reduction (3I⁻ → I₃⁻ + 2e⁻) of iodine ions in the electrolyte layer 130, and then are reduced. Herein, the oxidized iodine ions (I₃⁻) are reduced again by electrons that reach the counter electrode 120. As a result, the operation of the dye-sensitized solar cell 100 is completed.

As described above, the semiconductor electrode 110 is constituted such that the nanoparticles 114 comprising the oxide semiconductor are formed between the nanorods 113 and on the top surface of the nanorods 113. Thus, in terms of the operation process of the dye-sensitized solar cell 100 according to the present invention, a path in which the electrons transferred from the dyes 117 are transferred to the nanorods 113, which is the conductor, via the nanoparticles 114 comprising the oxide semiconductor can be significantly reduced, and the surface area of the conductor significantly increases. Thus, recombination between the electrolyte in the electrolyte layer 130 and the electrons transferred from the dyes 117 after being excited can be minimized. As a result, photoelectron conversion efficiency can be maximized.

The dye-sensitized solar cell 100 described above can be applied in a variety of electrical devices, for example, portable electronic devices, such as power suppliers for home, automobiles, ships, airplanes, traffic lights, outdoor advertisements, mobile phones, and MP3 players. In addition, the dye-sensitized solar cell 100 may be applied in industrial equipment, however, the present invention is not limited to the above examples.

Hereinafter, a method of manufacturing the dye-sensitized solar cell 100 will be described.

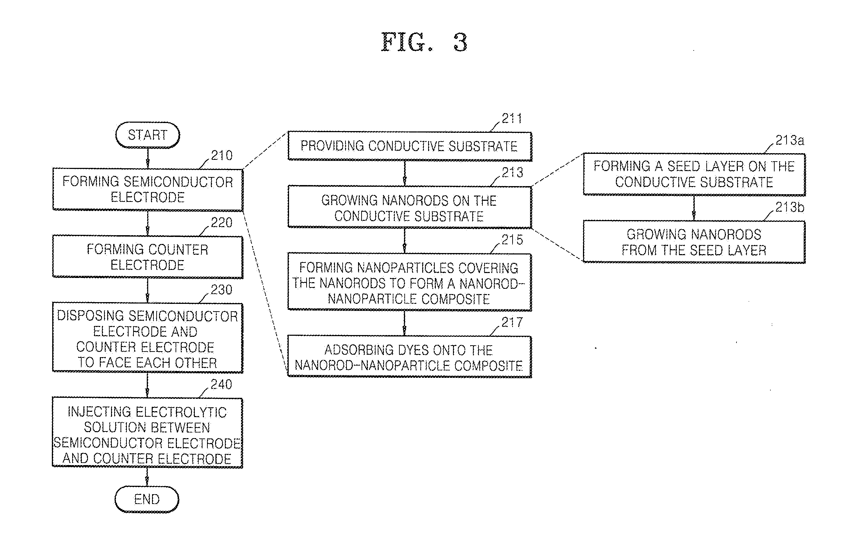

FIG. 3 is a flowchart illustrating a method of manufacturing the dye-sensitized solar cell 110, according to an embodiment of the present invention.

Referring to FIGS. 1 through 3, the semiconductor electrode 110 is formed in operation 210, the counter electrode 120 is formed in operation 220, and the semiconductor electrode 110 and the counter electrode 120 are disposed to face each other in operation 230. Then, in operation 240, an electrolytic solution is injected between the semiconductor electrode 110 and the counter electrode 120 to form the electrolyte layer 130. In FIG. 3, operation 210 is followed by operation 220. However, operations 210 and 220 can be performed regardless of the order, and may also be performed simultaneously.

Each operation will be described in more detail. Operation 210 may include: preparing a conductive substrate (operation 211); growing nanorods on the conductive substrate (operation 213); forming nanoparticles covering the nanorods to form a nanorod-nanoparticle composite (operation 215); and adsorbing dyes onto the nanorod-nanoparticle composite.

The conductive substrate may be a substrate having configurations as described above, and thus a detailed description thereof is not provided here.

The growing of the nanorods on the conductive substrate may include growing the nanorods to have an integration degree of about 1% to about 10%. The reason for growing the nanorods to have such integration degree has been described above, and thus a description thereof will not be repeated.

More particularly, the growing of the nanorods on the conductive substrate may include forming a seed layer on the conductive substrate and growing the nanorods from the seed layer.

The seed layer may be formed by thermal deposition, sputtering, or spin coating. In thermal deposition, a reactant gas is deposited at a high temperature, and sputtering refers to physical vapor deposition that is performed on a material to be deposited, used as a target material. In spin coating, a seed material in the form of nanoparticles is dispersed in a dispersing medium to prepare the seed material in a slurry form, and then the resultant is spin coated and dried to form a seed layer. These methods are well known in the art, and thus detailed descriptions thereof are not provided here.

If the nanorods to be grown are ZnO nanorods, the seed material may be ZnO, and if the nanorods to be grown are carbon nanorods, the seed material may be carbon particles.

The growing of the nanorods from the seed layer may be performed by vapor deposition or hydrothermal synthesis. The vapor deposition may be performed on the nanorods at a temperature in a range of about 400°C to about 700°C for about 30 minutes to about 30 hours.

To more efficiently grow the nanorods, operation 210 may further include pre-treating the surface of the conductive substrate with organic molecules having a functional group, wherein the organic molecules can be self-assembled on the nanoparticles by a selective chemical binding between the functional group and the nanoparticles, before the growing of the nanorods on the conductive substrate.

The organic molecules may be selected from organic molecules having a functional group, wherein the organic molecules can be self-assembled by the selective chemical binding only on a surface of a metal oxide, such as a silane compound, a phosphoric acid compound, a sulfuric acid compound, a carboxylic acid compound, or the like.

The silane compound may have any one of the structures selected from the group consisting of R₁SiHR₂R₃, R₁SiXR₂R₃ where X is Cl, Br, or I, and R₁SiRR₂R₃ where R is methoxy, ethoxy, or *t*-butoxy, wherein R₁, R₂, and R₃ are each independently a fluorine-substituted or unsubstituted C₁-C₂₄ alkane, alkene, or alkyne.

The phosphoric acid compound may have a functional group selected from the group consisting of -PO₄, -PO₃, -PO₂, and -PO, and may have a structure of PR₁R₂R₃R₄ where R₁, R₂, R₃, and R₄ are each independently a fluorine-substituted or unsubstituted C₁-C₂₄ alkane, alkene, or alkyne, and at least one of R₁, R₂, R₃, and R₄ is -OH or -O. In particular, when at least one of R₁, R₂, R₃, and R₄ is -O, the phosphoric acid compound can exist in the form of a complex conjugated with a metal ion.

The sulfuric acid compound may have a functional group selected from the group consisting of -SO₄, -SO₃, -SO₂, and -SO, and may have a structure of SR₁R₂R₃R₄ where R₁, R₂, R₃, and R₄ are each independently a fluorine-substituted or unsubstituted C₁-C₂₄ alkane, alkene, or alkyne, and at least one of R₁, R₂, R₃, and R₄ is -OH or -O. In particular, the sulfuric acid compound can exist in the form of a complex conjugated with a metal ion.

The carboxylic acid compound may have a functional group such as -COOH or -COO-, and may have a structure of R₂COO- where R₁ and R₂ are each independently a fluorine-substituted or unsubstituted C₁-C₂₄ alkane, alkene, or alkyne.

A seed for the growing of the nanorods is positioned on a portion in which the organic molecules are not formed on the conductive substrate of which surface is pre-treated with the organic molecules, and the nanorods grow therefrom. After the growing of the nanorods, heat treatment may be performed on the pre-treated conductive substrate to remove the organic molecules. The heat treatment may be performed at a temperature in a range of about 100°C to about 500°C for about 30 minutes to about 4 hours in an oxygen atmosphere. When the heat treatment is performed at a temperature less than 100°C or for less than 30 minutes, the removal of the organic molecules may be insufficient. On the other hand, when the heat treatment is performed at a temperature greater than 500°C or for greater than 4 hours, the effects obtained by the heat treatment are saturated, and thus this is uneconomical.

The forming of the seed of the nanorods by forming the organic molecules is not inevitable in the growing of the nanorods, but can be efficient to grow the nanorods.

In addition, the integration degree of the nanorods may be adjusted by the formation of the organic molecules. That is, a degree by which the surface of the conductive substrate is exposed can be controlled by adjusting the concentration of the organic molecules, and the integration degree of the nanorods can be indirectly controlled therethrough. The concentration of the organic molecules, such that the nanorods have an integration degree of 1% to 10%, varies according to a type of the organic molecules used, whether the complex is formed, and the like. Thus, while it is difficult to initially determine the appropriate concentration of the organic molecules, the concentration can be determined through repetitive simple experiments.

After the growing of the nanorods, the nanoparticles are formed in order to cover the nanorods to form the nanorod-nanoparticle composite (refer to operation 215). The nanoparticles may comprise an oxide semiconductor as described above. Examples of the oxide semiconductor may include titanium dioxide (TiO₂), tin dioxide (SnO₂), zinc oxide (ZnO), tungsten oxide (WO₃), niobium oxide (Nb₂O₅), titanium strontium oxide (TiSrO₃), and a combination thereof. The nanoparticles are dispersed in a solution in which a polymer binder is dissolved in an organic solvent, and then are coated on the conductive substrate on which the nanorods are grown. The coating may be screen printing, spray coating, coating using a doctor blade, gravure coating, dip coating, silk screening, painting, spin coating, or the like, according to the viscosity of a composition, but the present invention is not limited thereto.

The polymer binder may comprise, for example, at least one of ethyl cellulose and terpineol, and the organic solvent may be any organic solvent which can dissolve the polymer binder, but the present invention is not limited thereto.

The layer coated using the coating method described above is heat treated at a temperature in a range of about 100 to about 600°C to remove the polymer binder from the nanoparticles. Thus, the nanorod-nanoparticle composite constituted in such a manner that the nanorods are covered by a plurality of the nanoparticles is formed.

Then, dye molecules are adsorbed onto the surface of the nanoparticles of the nanorod-nanoparticle composite. The dye molecules may be adsorbed at a temperature in a range of about 100°C to about 140°C. This is for preventing the surface of the nanoparticles from being contaminated due to water. That is, when the dye molecules are adsorbed in a non-humidified condition, crystallinity of the nanoparticles can be improved. As a result, contact properties between the nanoparticles are improved, resulting in smoother electron transfer.

In operation 220, the counter electrode 120 may be formed by forming the metallic layer 124 on the electrically conductive substrate 122. The metallic layer 124 may be, for example, a platinum layer.

In operation 230, the semiconductor electrode 110 is disposed to face the counter electrode 120. For this, a polymer layer that comprises, for example, SURLYN^{®} (Product name, manufactured by Du Pont) and having a thickness of about 30 µm to about 50 µm is disposed between the conductive substrate 112 and the electrically conductive substrate 122 for the counter electrode. Then, the conductive substrate 112 and the electrically conductive substrate 122 are pressed together on a hot plate at a temperature of about 100°C to about 140°C, at about 1 atm to about 3 atm. As a result, the polymer layer is strongly adhered to the surfaces of the semiconductor electrode 110 and the counter electrode 120 due to the applied heat and pressure.

In operation 240, an electrolytic solution is injected into a space between the semiconductor electrode 110 and the counter electrode 120. After the space is filled with the electrolytic solution, the polymer layer and the conductive substrates 112 and 122 are instantaneously heated to seal the injection inlet.

Through the processes described above, a dye-sensitized solar cell according to an embodiment of the present invention can be manufactured.

The present invention will now be described in further detail with reference to the following examples. These examples are for illustrative purposes only and are not intended to limit the scope of the present invention.

### <Example>

1.10 g of zinc acetate dehydrate (molecular weight of 219.5, manufactured by Aldrich) was baked at 180°C for about 1 hour, and then added to 50 ml of ethanol and mixed together. Then, the mixture was left to sit at 60°C for 30 minutes. The resultant was then dried in a nitrogen atmosphere, added again to 50 ml of ethanol, and then refluxed at 60°C for about 2 hours. Then, the resultant was centrifugally separated to remove particles and the remaining dispersing solution was stored at 5°C.

The dispersing solution was dried to remove some of ethanol, resulting in preparation of a slurry. Then, the slurry was coated on a glass substrate coated with indium tin oxide (ITO) by screen printing. The resultant was placed in a second zone of a reactor for chemical vapour deposition, and a mixed powder of zinc oxide and carbon in a weight ratio of 1:1 was placed in a first zone of the reactor, so that a reaction gas can be transferred to a top surface of the glass substrate placed in the second zone of the reactor.

Then, the temperature of the first zone was maintained at about 900°C, and the temperature of the second zone was maintained at about 400°C to grow ZnO nanorods for 24 hours. Herein, the reactor was in a nitrogen atmosphere. As a result, nanorods having a length of 1.5 µm were obtained.

A powder formed of TiO₂ nanoparticles was dispersed in isopropylalcohol to form a paste. Then, the paste was dispersed on the conductive substrate on which the ZnO nanorods were grown by screen printing to a thickness of 12 µm. The resultant was then heat treated at 120°C for 4 hours.

Then, dyes were adsorbed onto the surface of a layer formed of TiO₂ using an alcohol solution in which a ruthenium dye, that is, 4,4'-dicarboxy-2,2-bupyridine)bis(thiocyanato) ruthenium(II):N3 was dissolved, thereby forming a semiconductor electrode.

Separately, a conductive glass substrate on which a H₂PtCl₆ solution was coated was sintered at 450°C for 30 minutes to prepare a counter electrode.

The prepared semiconductor electrode and counter electrode were disposed in such a manner that conductive surfaces of the semiconductor and counter electrodes faced each other. Then, a polymer layer formed of SURLYN^{®} (product name, manufactured by Du Pont) was interposed therebetween, and the semiconductor electrode and the counter electrode were pressed together. Then, an electrolytic solution was filled between a space between the semiconductor and counter electrodes. The electrolytic solution used was a I₃⁻/I⁻ electrolytic solution obtained by dissolving 0.70 M of 1-vinyl-3-methyl-imidazolium iodide, 0.10 M of Lil, 40 mM of I₂ and 0.125 M of 4-*tert*-butylpyridine in 3-methoxypropionitrile.

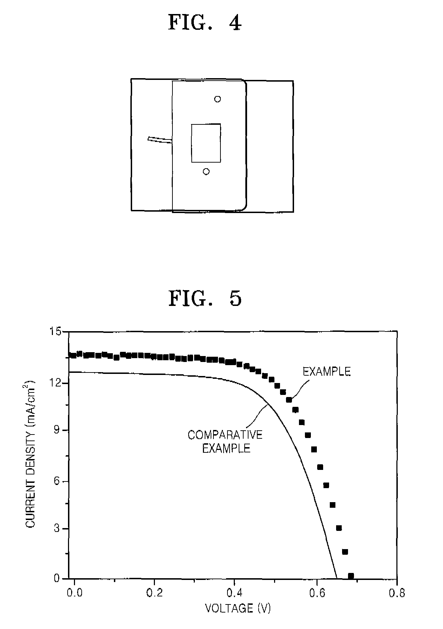

As a result, the manufacture of a dye-sensitized solar cell as illustrated in FIG. 4 was completed.

### <Comparative Example>

A dye-sensitized solar cell was manufactured in the same manner as in Example, except that the growing of the nanorods was omitted.

To evaluate photoelectron conversion efficiency of each of the dye-sensitized solar cell manufactured in Example and Comparative Example, photo voltages and photo currents were measured using the following method. For this, a Keithley 2400 SourceMeter^{®}, that is, a solar simulator, was used, and a Xenon lamp (Oriel, 91193) was used as a light source.

FIG. 5 is a graph showing current density and voltage characteristics of each of the dye-sensitized solar cells manufactured in Example and Comparative Example. As shown in FIG. 5, the dye-sensitized solar cell of Example has increased open-circuit voltage and improved current density, as compared with the dye-sensitized solar cell of Comparative Example. Electrical characteristics of each of the dye-sensitized solar cells of Example and Comparative Example are shown in Table 1 below. As shown in Table 1, the efficiency of the dye-sensitized solar cell of Example is higher, that is, by about 10%, than that of the dye-sensitized solar cell of Comparative Example.

**<Table 1>**

| | Open-circuit voltage, V (V_{OC}) | Short circuit current, mA/cm² (JSC) | fill factor | efficiency (%) |
|---|---|---|---|---|
| Example | 0.687 | 13.61 | 0.642 | 5.84 |
| Comparative Example | 0.654 | 12.71 | 0.630 | 5.23 |

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. A dye-sensitized solar cell comprising: a semiconductor electrode and a counter electrode that face each other, and an electrolytic solution interposed therebetween,
wherein the semiconductor electrode comprises:
a conductive substrate;
a nanorod-nanoparticle composite formed on the conductive substrate; and
dyes adsorbed onto the surface of the nanoparticles.

2. The dye-sensitized solar cell of claim 1, wherein, in the nanorod-nanoparticle composite, the nanorods are electrically connected to the conductive substrate, and are covered by a layer formed of the nanoparticles, the nanoparticles comprising an oxide semiconductor.

3. The dye-sensitized solar cell of claim 2, wherein one end of each of the nanorods is attached to the conductive substrate.

4. The dye-sensitized solar cell of any of the preceding claim, wherein the length of the nanorods is in a range of about 1 µm to about 10 µm.

5. The dye-sensitized solar cell of any of the preceding claims, wherein the thickness of the layer formed of the nanoparticles is in a range of about 5 µm to about 15 µm.

6. The dye-sensitized solar cell of any of the preceding claims, wherein the thickness of the nanorods is in a range of about 10 nm to about 30 nm.

7. The dye-sensitized solar cell of any of the preceding claim, wherein the size of the nanoparticles is in a range of about 10 nm to about 40 nm.

8. The dye-sensitized solar cell of any of the preceding claims, wherein an integration degree of the nanorods is in a range of about 1% to about 10%.

9. The dye-sensitized solar cell of any of the preceding claims, wherein the nanorods comprise zinc oxide or carbon.

10. The dye-sensitized solar cell of any of the preceding claims, wherein the nanoparticles comprise one selected from the group consisting of titanium dioxide (TiO₂), tin dioxide (SnO₂), zinc oxide (ZnO), tungsten oxide (WO₃), niobium oxide (Nb₂O₅), titanium strontium oxide (TiSrO₃), and a combination thereof.

11. A method of manufacturing a dye-sensitized solar cell, comprising:
forming a semiconductor electrode;
forming a counter electrode;
disposing the semiconductor electrode and the counter electrode to face each other; and
injecting an electrolytic solution between the semiconductor electrode and the counter electrode,
wherein the forming of the semiconductor electrode comprises:
providing a conductive substrate;
growing nanorods on the conductive substrate;
forming nanoparticles covering the nanorods to form a nanorod-nanoparticle composite; and
adsorbing dyes onto the nanorod-nanoparticle composite.

12. The method of claim 11, further comprising:
pre-treating the surface of the conductive substrate with organic molecules having a functional group, wherein the organic molecules are capable of being self-assembled on the nanoparticles by a selective chemical binding between the functional group and the nanoparticles, before the growing of the nanorods on the conductive substrate, and
performing heat treatment for removing the organic molecules after the growing of the nanorods on the conductive substrate.

13. The method of claim 12, wherein the heat treatment is performed at a temperature in a range of about 100°C to about 500°C for about 30 minutes to about 4 hours in an oxygen atmosphere.

14. The method of any of claims 11 to 13, wherein the growing of the nanorods on the conductive substrate comprises growing the nanorods to have an integration degree of about 1% to about 10%.

15. The method of any of claims 11 to 14, wherein the growing of the nanorods on the conductive substrate comprises:
forming a seed layer on the conductive substrate; and
growing nanorods from the seed layer.
